# EUROPEAN PATENT SPECIFICATION

(11) **EP 2 903 037 B1**
(45) Date of publication and mention of the grant of the patent: **07.09.2016**
(21) Application number: 14004257.3
(22) Date of filing: 17.12.2014
(51) Int. Cl.: H01L 31/0745, H01L 31/0368, H01L 31/18, H01L 31/20

(54) **Fabrication method for back-contact heterojunction solar cell**
Herstellungsverfahren für rückseitig kontakierte Solarzelle mit Heteroübergang
Procédé de fabrication d' une cellule solaire à contact arrière à hétérojonction

(30) Priority: 29.01.2014 KR 20140011471
(43) Date of publication of application: 05.08.2015
(73) Proprietor: LG Electronics Inc., Yeongdeungpo-gu Seoul 150-721 (KR)
(72) Inventor: LEE, Yujin, 153-802 Seoul (KR); JI, Kwangsun, 153-802 Seoul (KR); LEE, Seungjik, 153-802 Seoul (KR); AHN, Sehwon, 153-802 Seoul (KR)
(74) Representative: Katérle, Axel

(56) References cited:
- US-A- 5 057 439
- US-A1- 2009 308 438
- US-A1- 2012 073 650
- US-A1- 2013 026 479
- US-A1- 2013 087 783
- US-B2- 8 633 379
- SALEH R ET AL: "Structural properties of phosphorous-doped polycrystalline silicon", SOLAR ENERGY MATERIALS AND SOLAR CELLS, ELSEVIER SCIENCE PUBLISHERS, AMSTERDAM, NL, vol. 90, no. 18-19, 23 November 2006 (2006-11-23), pages 3456-3463, XP028002328, ISSN: 0927-0248, DOI: 10.1016/J.SOLMAT.2005.10.026 [retrieved on 2006-11-23]

## Description

### BACKGROUND OF THE INVENTION

### Field of the Invention

The invention relates to a method for manufacturing a solar cell.

### Description of the Related Art

Recently, as existing energy sources such as petroleum and coal are expected to be depleted, interests in alternative energy sources for replacing the existing energy sources are increasing. Among the alternative energy sources, solar cells for generating electric energy from solar energy have been particularly spotlighted because the solar cells have abundant energy sources and do not cause environmental pollution.

A solar cell generally includes a substrate and an emitter region, which are formed of semiconductors of different conductive types, for example, a p-type and an n-type, and electrodes respectively connected to the substrate and the emitter region. A p-n junction is formed at an interface between the substrate and the emitter region.

When light is incident on the solar cell, a plurality of electron-hole pairs are generated in the semiconductors. The electron-hole pairs are separated into electrons and holes by a photovoltaic effect. The electrons move to the n-type semiconductor, for example, the emitter region, and the holes move to the p-type semiconductor, for example, the substrate. Then, the electrons and the holes are collected by the electrodes electrically connected to the emitter region and the substrate. The solar cell obtains electric power by connecting the electrodes using electric wires.

The plurality of electrodes electrically connected to the emitter region and the substrate are positioned on the emitter region and the substrate, collect carriers moving to the emitter region and the substrate, and move the carriers to a load connected to the outside.

However, in this instance, the electrodes are positioned on the emitter region formed on the surface (i.e., an incident surface) of the substrate, on which light is incident, as well as the surface of the substrate, on which light is not incident. Therefore, an incident area of light decreases, and the efficiency of the solar cell is reduced.

Thus, a back contact solar cell, in which all of the electrodes collecting electrons and holes are positioned on a back surface of the substrate, has been developed, so as to increase the incident area of light.

US 2012/0073650 discloses a method for fabricating a back-contact solar cell comprising forming a tunnel oxide layer on a surface of a silicon substrate, forming an amorphous silicon layer on the tunnel oxide layer, doping the amorphous silicon layer to provide a first region including N-type dopants and a second region including P-type dopants and, subsequently, heating the doped amorphous layer to provide a polycrystalline layer having N-type doped and P-type doped regions.

### SUMMARY OF THE INVENTION

The invention is a method for manufacturing a solar cell, as defined in claim 1, including forming an amorphous silicon layer on a back surface of a crystalline semiconductor substrate containing impurities of a first conductive type, performing a first diffusion process for diffusing impurities of a second conductive type opposite the first conductive type into a portion of the amorphous silicon layer to form an emitter region, and performing a second diffusion process for diffusing impurities of the first conductive type into a remaining portion except the portion of the amorphous silicon layer having the impurities of the second conductive type to form a back surface field region, wherein when the first diffusion process and the second diffusion process is performed, the amorphous silicon layer is crystallized to form a silicon layer, having
crystallinity of 20 % to 80 %.

The first diffusion process and the second diffusion process are simultaneously performed. It may be preferable, but not required, that the amorphous silicon layer is crystallized at a temperature equal to or higher than 500 °C. when the first diffusion process and the second diffusion process are performed.

The method further includes, before performing the first diffusion process and the second diffusion process, performing a dehydrogenation process on the amorphous silicon layer. The dehydrogenation process may be performed at a temperature of 300 to 600 °C.

The amorphous silicon layer may have a thickness of 20 nm to 300 nm. The amorphous silicon layer may be formed at a temperature lower than a temperature of the at least one of the first diffusion process and the second diffusion process, for example, at a temperature equal to or lower than 250 °C.

The method may further include, before performing the first diffusion process, forming a first dopant layer containing impurities of the second conductive type on a back surface of the amorphous silicon layer. The method may further include, before performing the second diffusion process, forming a second dopant layer containing impurities of the first conductive type on a back surface of the amorphous silicon layer.

In another aspect, not forming part of the invention and not covered by the claims there is disclosed a solar cell including a semiconductor substrate of a first conductive type, a plurality of emitter regions, each of which has a second conductive type opposite the first conductive type and forms a p-n junction along with the semiconductor substrate, a plurality of back surface field regions, each of which is more heavily doped with impurities of the first conductive type than the semiconductor substrate, a plurality of first electrodes electrically connected to the plurality of emitter regions, and a plurality of second electrodes electrically connected to the plurality of back surface field regions, wherein each emitter region and each back surface field region contain silicon having crystallinity of 20 % to 80 %.

The emitter regions and the back surface field regions are alternately positioned on the same level layer.

The solar cell may further include a first tunnel junction layer positioned on a front surface of the semiconductor substrate and a second tunnel junction layer positioned on a back surface of the semiconductor substrate. The first and second tunnel junction layers may be formed of intrinsic hydrogenated amorphous silicon (a-Si:H). The first and second tunnel junction layers may have the same thickness or different thicknesses. The first and second tunnel junction layers may have a thickness of 1 nm to 4 nm.

### BRIEF DESCRIPTION OF THE DRAWINGS

The accompanying drawings, which are included to provide a further understanding of the invention and are incorporated in and constitute a part of this specification, illustrate embodiments of the invention and together with the description serve to explain the principles of the invention. In the drawings:
FIG. 1 is a partial perspective view of a disclosed solar cell not forming part of the invention;
FIG. 2 is a cross-sectional view taken along line II-II of FIG. 1;
FIGS. 3A to 3L sequentially illustrate a method for manufacturing a solar cell according to a first embodiment of the invention; and
FIGS. 4A to 4G sequentially illustrate a further disclosed method for manufacturing an emitter region and a back surface field region which does not form part of the invention.

### DETAILED DESCRIPTION OF THE EMBODIMENTS

Reference will now be made in detail to embodiments of the invention, examples of which are illustrated in the accompanying drawings. This invention may, however, be embodied in many different forms and should not be construed as limited to the embodiments set forth herein. Wherever possible, the same reference numbers will be used throughout the drawings to refer to the same or like parts. It will be noted that a detailed description of known arts will be omitted if it is determined that the detailed description of the know arts can obscure the embodiments of the invention.

In the drawings, the thickness of layers, films, panels, regions, etc., are exaggerated for clarity. It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, it will be understood that when an element such as a layer, film, region, or substrate is referred to as being "entirely" on other element, it may be on the entire surface of the other element and may not be on a portion of an edge of the other element.

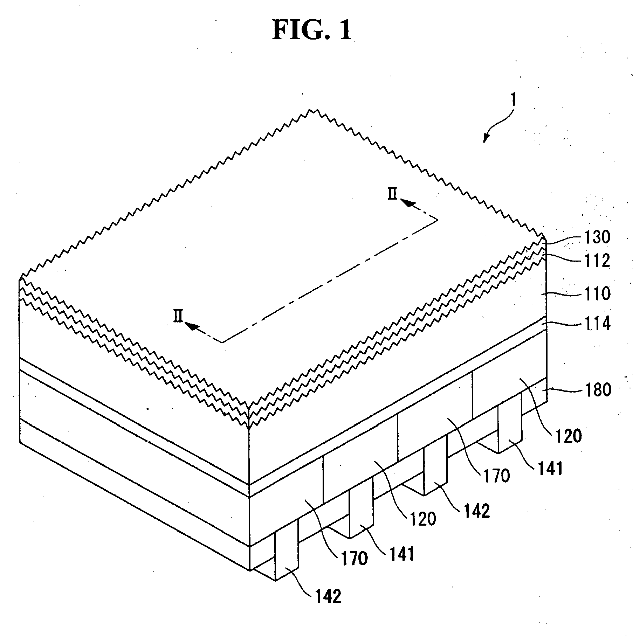

Example embodiments of the invention as well as solar cells and methods not forming part thereof are described below with reference to FIGS. 1 to 4G.

An exemplary solar cell and a method for manufacturing the same according to an example embodiment of the invention are described in detail with reference to the accompanying drawings.

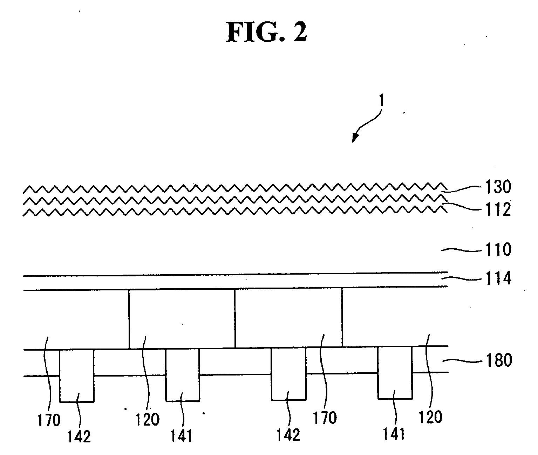

As shown in FIGS. 1 and 2, a disclosed solar cell 1 may include a substrate 110, a first intrinsic semiconductor layer 112 positioned on one surface (for example, a front surface, on which light is incident) of the substrate 110, an anti-reflection layer 130 positioned on a front surface of the first intrinsic semiconductor layer 112, a second intrinsic semiconductor layer 114 positioned on a back surface of the substrate 110, on which light is not incident, opposite the front surface of the substrate 110, a plurality of emitter regions 120 positioned at a back surface of the second intrinsic semiconductor layer 114, a plurality of back surface field (BSF) regions 170 which are positioned at the back surface of the second intrinsic semiconductor layer 114 and are positioned on the same level layer as the plurality of emitter regions 120, a diffusion barrier layer 180 positioned on back surfaces of the plurality of emitter regions 120 and back surfaces of the plurality of back surface field regions 170, a plurality of first electrodes 141 positioned on the plurality of emitter regions 120, and a plurality of second electrodes 142 positioned on the plurality of back surface field regions 170. The first intrinsic semiconductor layer 112, the second intrinsic semiconductor layer 114, the anti-reflection layer 130, and the diffusion barrier layer 180 may be omitted However, process efficiency and process yield of the solar cell when the solar cell includes the first intrinsic semiconductor layer 112, the second intrinsic semiconductor layer 114, the anti-reflection layer 130, and the diffusion barrier layer 180 are further improved. Therefore, the invention is described using the solar cell 1 including the components 112, 114, 130, and 180 as an example.

The substrate 110 may be formed of a silicon wafer of a first conductive type, for example, n-type, though not required. Silicon used in the substrate 110 may be crystalline silicon, such as single crystal silicon and polycrystalline silicon.

If the substrate 110 is of the n-type, the substrate 110 may contain impurities of a group V element such as phosphorus (P), arsenic (As), and antimony (Sb). However, on the contrary, the substrate 110 may be of a p-type and/or may be formed of semiconductor materials other than silicon. If the substrate 110 is of the p-type, the substrate 110 may contain impurities of a group III element such as boron (B), gallium (Ga), and indium (In).

The front surface of the substrate 110 is textured to form a textured surface corresponding to an uneven surface or having uneven characteristics.

The first intrinsic semiconductor layer 112 is positioned on the front surface, i.e., the textured surface of the substrate 110 and is formed between the substrate 110 and the anti-reflection layer 130. The first intrinsic semiconductor layer 112 may be formed of intrinsic hydrogenated amorphous silicon (a-Si:H). In this instance, the first intrinsic semiconductor layer 112 may have a thickness of 1 nm to 4 nm. The first intrinsic semiconductor layer 112 may be referred to as a front tunnel junction layer capable of generating a movement path of carriers, namely, a tunneling effect of the carriers.

The first intrinsic semiconductor layer 112 may be formed on the front of the substrate 110 using a chemical vapor deposition (CVD) method, such as plasma enhanced chemical vapor deposition (PECVD) method.

A junction of the substrate 110 and the first intrinsic semiconductor layer 112 is not a flat surface and has an uneven surface due to the textured surface of the substrate 110.

The anti-reflection layer 130 positioned on the front surface of the first intrinsic semiconductor layer 112 may be formed of silicon nitride (SiNx) or silicon oxide (SiOx). The anti-reflection layer 130 reduces a reflectance of light incident on the solar cell 1 and increases selectivity of light of a predetermined wavelength band, thereby increasing the efficiency of the solar cell 1. In the embodiment disclosed herein, the anti-reflection layer 130 has a single-layered structure, but may have a multi-layered structure such as a double-layered structure. The anti-reflection layer 130 may be omitted, if desired. The anti-reflection layer 130 has not a flat surface but an uneven surface due to the textured surface of the substrate 110 in the same manner as the first intrinsic semiconductor layer 112.

Each of the plurality of emitter regions 120 positioned at the back surface of the substrate 110 has a second conductive type (for example, p-type) opposite the first conductive type (for example, n-type) of the substrate 110 and is formed of a semiconductor material, for example, amorphous silicon different from the substrate 110. Thus, the emitter regions 120 form a hetero-junction as well as a p-n junction along with the substrate 110.

The plurality of emitter regions 120 are separated from one another and extend in parallel with one another in a fixed direction.

If the emitter regions 120 are of the p-type, the emitter regions 120 may contain impurities of a group III element such as boron (B), gallium (Ga), and indium (In). On the contrary, if the emitter regions 120 are of the n-type, the emitter regions 120 may contain impurities of a group V element such as phosphorus (P), arsenic (As), and antimony (Sb).

The emitter region 120 having the second conductive type opposite the first conductive type of the substrate 110 contains group III atoms as a dopant. Thus, because the group III atom obtains one electron so that the group III atom is bonded to silicon atom of the substrate 110, fixed charges of atoms existing at the surface of the emitter region 120 each have a negative (-) value. As a result, because fixed charges of the emitter regions 120 have a negative value opposite to those of holes having a positive (+) value, a movement of holes to the emitter regions 120 is accelerated.

The emitter region 120 formed of silicon (or a silicon layer) (which started off as amorphous silicon) has crystallinity of 20 % to 80 %. The crystallinity indicates a percentage of the volume of an amorphous silicon layer grown by a seed layer on the total volume of the emitter regions 120 and back surface field regions 170 as a layer stacked on the back surface of the substrate 110. Accordingly, the silicon (or the silicon layer) may be partially crystalline and partially amorphous.

When the crystallinity of the emitter regions 120 is equal to or less than 20 %, a contact resistance increases in the formation of the electrodes because conductivity of amorphous silicon forming the emitter regions 120 is very low. Hence, a fill factor FF is reduced.

When the crystallinity of the emitter regions 120 is equal to or greater than 80 %, a crystallization process performed at a high temperature for several tens of hours or a process using an expensive excimer laser is required to crystallize amorphous silicon. Thus the emitter regions 120 have the crystallinity of 20 % to 80 %.

The plurality of back surface field regions 170 are positioned to be separated from one another on the back surface of the substrate 110 and extend in parallel with one another in the same direction as the emitter regions 120. Thus, as shown in FIGS. 1 and 2, the plurality of emitter regions 120 and the plurality of back surface field regions 170 are alternately positioned on the back surface of the substrate 110. Namely, the plurality of emitter regions 120 and the plurality of back surface field regions 170 may be positioned on the same level layer.

The back surface field regions 170 may be formed of silicon. The back surface field region 170 may be a region (for example, n⁺ or n⁺⁺-type region) that is more heavily doped than the substrate 110 with impurities of the same conductive type as the substrate 110.

Accordingly, a potential barrier is formed by a difference between impurity concentrations of the substrate 110 and the back surface field regions 170, thereby preventing holes moving to the back surface of the substrate 110 from moving to the plurality of second electrodes 142. Hence, a recombination and/or a disappearance of electrons and holes around the second electrodes 142 may be prevented or reduced.

Because the back surface field region 170 has the same n-type as the substrate 110, the back surface field region 170 contains group V atoms as a dopant. Because one electron is removed from the group V atom so that the group V atom is bonded to silicon atom of the substrate 110, fixed charges of atoms existing at the surface of the back surface field region 170 each have a positive (+) value. As a result, because fixed charges of the back surface field regions 170 have the same positive value as holes serving as minority carriers in the substrate 110, holes are prevented from moving to the back surface field regions 170 due to an electrical repulsive force.

A plurality of electron-hole pairs produced by light incident on the substrate 110 is separated into electrons and holes. The separated electrons move to the n-type semiconductor, and the separated holes move to the p-type semiconductor. Thus, when the substrate 110 is of the n-type and the emitter regions 120 is of the p-type, the separated holes move to the plurality of emitter regions 120, and the separated electrons move to the plurality of back surface field regions 170 having the impurity concentration higher than the substrate 110.

Because the emitter regions 120 and the substrate 110 form the p-n junction, the emitter regions 120 may be of the n-type if the substrate 110 is of the p-type unlike the embodiment of the invention. Hence, the separated electrons may move to the plurality of emitter regions 120, and the separated holes may move to the plurality of back surface field regions 170.

The back surface field region 170 formed of silicon (or a silicon layer) (which started off as amorphous silicon) may have the crystallinity of 20 % to 80 % in the same manner as the emitter region 120.

The second intrinsic semiconductor layer 114 is positioned on the back surface of the substrate 110. The second intrinsic semiconductor layer 114 may be formed of intrinsic hydrogenated amorphous silicon (a-Si:H). In the embodiment disclosed herein, the second intrinsic semiconductor layer 114 may be referred to as a back tunnel junction layer capable of generating a movement path of carriers, namely, a tunneling effect of the carriers.

The first intrinsic semiconductor layer 112 and the second intrinsic semiconductor layer 114 may be formed of the same material. Further, the second intrinsic semiconductor layer 114 may have the same thickness as the first intrinsic semiconductor layer 112.

On the contrary, the first intrinsic semiconductor layer 112 and the second intrinsic semiconductor layer 114 may be formed of different materials and also may have different thicknesses.

The plurality of first electrodes 141 positioned on the plurality of emitter regions 120 extend along the emitter regions 120 and are electrically connected to the emitter regions 120.

Each first electrode 141 collects carriers (for example, holes) moving to the emitter region 120.

The plurality of second electrodes 142 positioned on the plurality of back surface field regions 170 extend along the back surface field regions 170 and are electrically connected to the back surface field regions 170.

Each second electrode 142 collects carriers (for example, electrons) moving to the back surface field region 170.

The plurality of first and second electrodes 141 and 142 may be formed of at least one conductive material selected from the group consisting of nickel (Ni), copper (Cu), silver (Ag), aluminum (Al), tin (Sn), zinc (Zn), indium (In), titanium (Ti), gold (Au), and a combination thereof. Other materials may be used.

As described above, the solar cell 1 has the structure, in which the plurality of first and second electrodes 141 and 142 are positioned on the back surface of the substrate 110, on which light is not incident, and the substrate 110 and the plurality of emitter regions 120 are formed of different types of semiconductors. An operation of the solar cell 1 having the above-described structure is described below.

When light irradiated onto the solar cell 1 is incident on the substrate 110 through the anti-reflection layer 130, a plurality of electron-hole pairs are generated in the substrate 110 by light energy produced based on the light incident on the substrate 110. Because the front surface of the substrate 110 is the textured surface, a light reflectance in the front surface of the substrate 110 is reduced. Further, because both a light incident operation and a light reflection operation are performed on the textured surface of the substrate 110, a light absorption increases. Hence, the efficiency of the solar cell 1 is improved. In addition, because a reflection loss of light incident on the substrate 110 is reduced by the anti-reflection layer 130, an amount of light incident on the substrate 110 further increases.

The plurality of electron-hole pairs generated by the light incident on the substrate 110 is separated into holes and electrons by the p-n junction of the substrate 110 and the plurality of emitter regions 120. The separated holes move to the p-type emitter regions 120 and then are collected by the first electrodes 141, and the separated electrons move to the n-type back surface field regions 170 and then are collected by the second electrodes 142. When the first electrodes 141 and the second electrodes 142 are connected using electric wires, current flows therein to thereby enable use of the current for electric power.

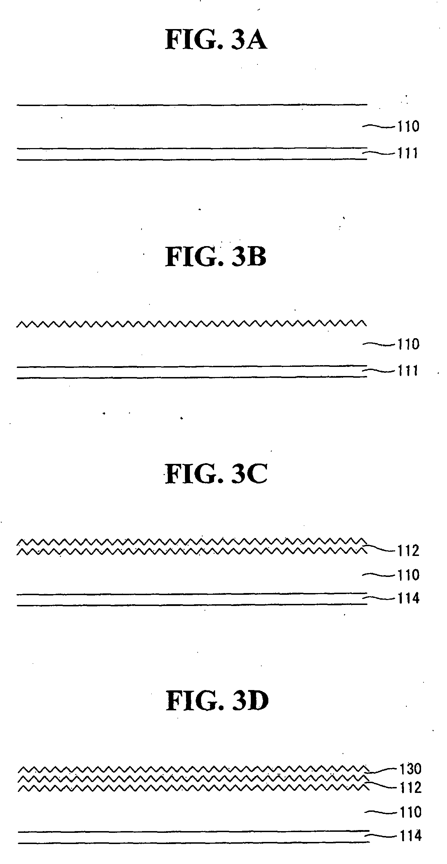

Hereinafter, a method for manufacturing the solar cell 1 according to the invention is described with reference to FIGS. 3A to 3L.

As shown in FIG. 3A, the semiconductor 110 formed of n-type single crystal silicon is prepared, and an etch stop layer 111 formed of silicon oxide (SiOx), etc., is stacked on one surface, for example, the back surface of the semiconductor 110.

Next, as shown in FIG. 3B, the other surface, for example, the front surface of the semiconductor 110, on which the etch stop layer 111 is not formed, is etched using the etch stop layer 111 as a mask to form a textured surface having a plurality of uneven portions on the front surface of the semiconductor 110, on which light is incident. Then, the etch stop layer 111 is removed. If the semiconductor 110 is formed of single crystal silicon, the surface of the substrate 110 may be textured using an alkaline solution such as KOH, NaOH, and TMAH. On the other hand, if the semiconductor 110 is formed of polycrystalline silicon, the surface of the substrate 110 may be textured using an acid solution such as HF and HNO₃.

Next, as shown in FIG. 3C, the first and second intrinsic semiconductor layers 112 and 114 are respectively formed on the front surface and the back surface of the n-type substrate 110. The first and second intrinsic semiconductor layers 112 and 114 are formed of intrinsic hydrogenated amorphous silicon (a-Si:H) and may have a thickness of 1 nm to 4nm. In the embodiment disclosed herein, the first and second intrinsic semiconductor layers 112 and 114 may serve as a moving path of carriers. A junction of the substrate 110 and the first intrinsic semiconductor layer 112 is not a flat surface and has an uneven surface due to the textured surface of the substrate 110.

The first and second intrinsic semiconductor layers 112 and 114 may be formed on the front surface and the back surface of the substrate 110 using a chemical vapor deposition (CVD) method, such as plasma enhanced chemical vapor deposition (PECVD) method.

Next, as shown in FIG. 3D, silicon nitride is deposited on the first intrinsic semiconductor layer 112 to form the anti-reflection layer 130. The anti-reflection layer 130 is formed on an entire front surface of the first intrinsic semiconductor layer 112.

The anti-reflection layer 130 may be formed using the PECVD method or a sputtering method. The anti-reflection layer 130 has not a flat surface but an uneven surface due to the textured surface of the substrate 110.

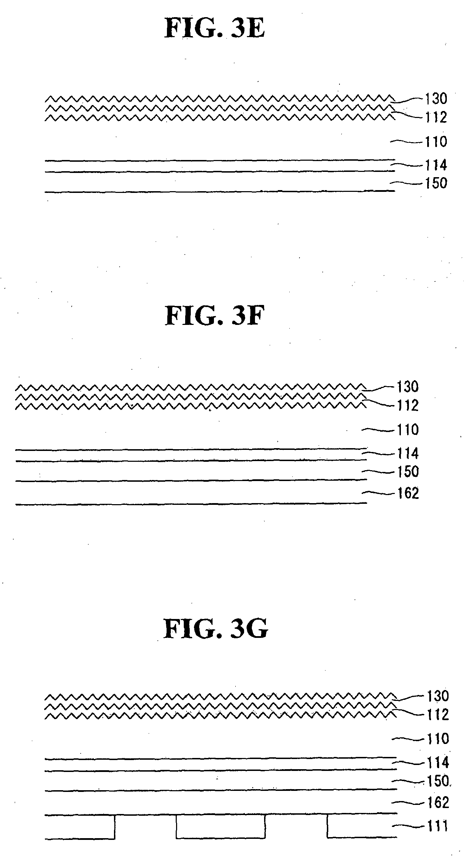

Next, as shown in FIG. 3E, an amorphous silicon layer 150 is formed on the second intrinsic semiconductor layer 114 using the CVD method such as the PECVD method. The amorphous silicon layer 150 is formed of intrinsic hydrogenated amorphous silicon (a-Si:H).

In the embodiment of the invention, the amorphous silicon layer 150 may be formed at a low temperature equal to or lower than 250 °C to have a thickness of 20 nm to 300 nm.

Next, as shown in FIG. 3F, a first dopant layer 162 containing impurities of a second conductive type opposite a first conductive type of the substrate 110 is formed on the amorphous silicon layer 150. In the embodiment of the invention, because the substrate 110 is of an n-type, the first dopant layer 162 contains impurities of a group III element of a p-type. The first dopant layer 162 may be formed using the CVD method such as the PECVD method.

Next, as shown in FIG. 3G, an etch stop layer 111 is stacked on the first dopant layer 162.

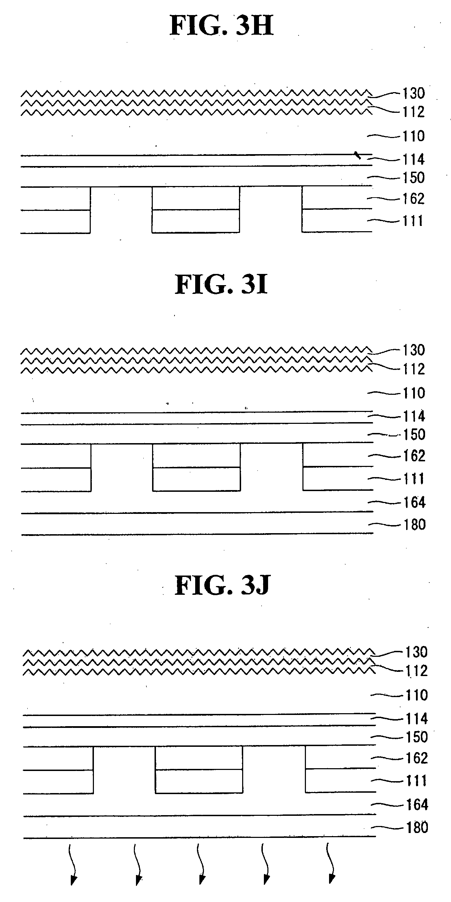

Next, as shown in FIG. 3H, a portion of the first dopant layer 162, on which the etch stop layer 111 is not formed, is etched using the etch stop layer 111 as a mask to expose a portion of the amorphous silicon layer 150.

Next, as shown in FIG. 3I, a second dopant layer 164 containing impurities of the first conductive type is formed on the exposed portion of the amorphous silicon layer 150 and the etch stop layer 111. In the embodiment of the invention, because the substrate 110 is of the n-type, the second dopant layer 164 contains impurities of a group V element of the n-type. The second dopant layer 164 may be formed using the same method as the first dopant layer 162.

Next, the diffusion barrier layer 180 is formed on an entire back surface of the second dopant layer 164. The diffusion barrier layer 180 prevents a diffusion of the second dopant layer 164 and is formed of an insulating material such as a polymer material.

Next, as shown in FIG. 3J, a dehydrogenation process is performed on the amorphous silicon layer 150 to remove hydrogen contained in the amorphous silicon layer 150. It is preferable, but not required, that the dehydrogenation process is performed at 300 to 600 °C.

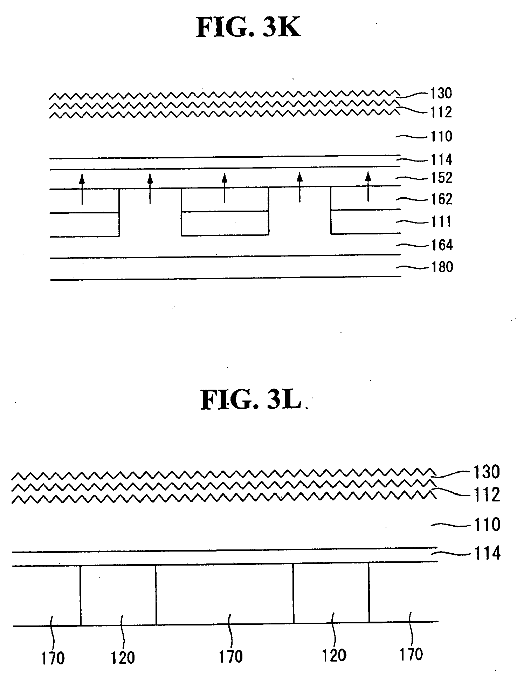

Next, as shown in FIGS. 3K and 3L, impurities of the first dopant layer 162 and impurities of the second dopant layer 164 are diffused to crystallize the amorphous silicon layer 150 at the high temperature. Hence, the plurality of emitter regions 120 and the plurality of back surface field regions 170 are formed. Also, a crystal layer (or a silicon layer) 152, in which at least a portion of the amorphous silicon layer 150 is crystallized, may be formed thereby.

More specifically, a first diffusion process for diffusing second conductive type impurities of the first dopant layer 162 into a portion of the amorphous silicon layer 150 may be performed. Further, a second diffusion process for diffusing first conductive type impurities of the second dopant layer 164 into a remaining portion except the portion of the amorphous silicon layer 150 may be performed. The first diffusion process and the second diffusion process may be simultaneously performed. The first diffusion process and the second diffusion process may be performed at a high temperature equal to or higher than 500 °C.

As described above, the portion of the amorphous silicon layer 150, into which the second conductive type impurities are diffused through the first diffusion process, is formed as the plurality of emitter regions 120. Further, the remaining portion except the portion of the amorphous silicon layer 150, into which the first conductive type impurities are diffused through the second diffusion process, is formed as the plurality of back surface field regions 170. Namely, the plurality of emitter regions 120 contains impurities of the second conductive type (for example, the p-type) opposite the first conductive type of the substrate 110. Each of the plurality of back surface field regions 170 may be formed as a region (for example, n⁺ or n⁺⁺-type region) that is more heavily doped than the substrate 110 with impurities of the same conductive type as the n-type substrate 110. The plurality of emitter regions 120 and the plurality of back surface field regions 170 may be alternately formed. The plurality of emitter regions 120 and the plurality of back surface field regions 170 may be positioned on the same level layer.

At the same time, at least a portion of the amorphous silicon layer 150 forming the plurality of emitter regions 120 and the plurality of back surface field regions 170 may be crystallized to form the crystal layer (or silicon layer) 152. In the embodiment of the invention, the plurality of emitter regions 120 and the plurality of back surface field regions 170 formed of silicon may have the crystallinity of 20 % to 80 %.

A diffusion barrier layer 180 may be additionally formed between the emitter regions 120 and the back surface field regions 170 and may prevent the emitter regions 120 and the back surface field regions 170 from being diffused.

Next, the plurality of first electrodes 141 are formed on the plurality of emitter regions 120, and the plurality of second electrodes 142 are formed on the plurality of back surface field regions 170. Hence, the solar cell 1 shown in FIG. 1 is completed.

More specifically, the plurality of first and second electrodes 141 and 142 may be formed by applying an electrode paste to back surfaces of the emitter regions 120 and back surfaces of the back surface field regions 170 using a screen printing method and then sintering the electrode paste. However, on the contrary, the plurality of first and second electrodes 141 and 142 may be formed using a plating method, a sputtering method, an electron beam deposition method, the CVD method such as the PECVD method, and the like.

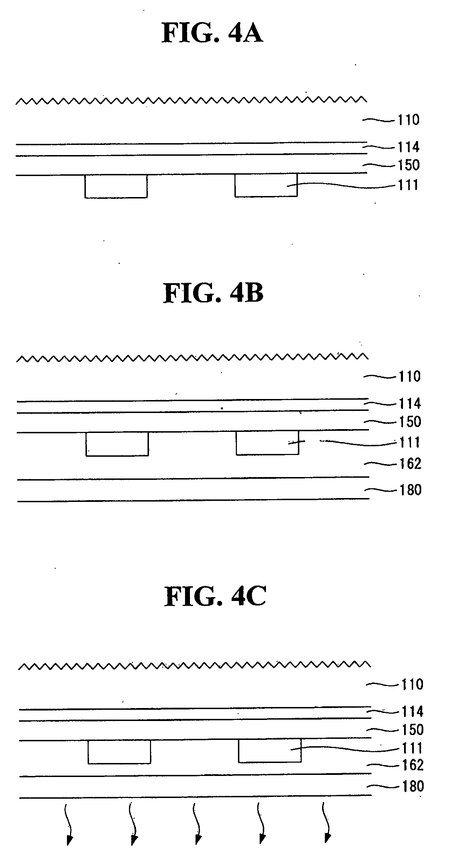

Hereinafter, a solar cell including an emitter region and a back surface field region fabricated according to an alternative method not forming part of the invention and not covered by the claims is described with reference to FIGS. 4A to 4G. FIGS. 4A to 4G sequentially illustrate said alternative disclosed method for forming an emitter region and a back surface field region which does not form part of the invention.

Structures and components identical or equivalent to those illustrated in FIG. 1 are designated with the same reference numerals, and a further description may be briefly made or may be entirely omitted.

As shown in FIG. 4A, an amorphous silicon layer 150 is formed on the second intrinsic semiconductor layer 114 using a chemical vapor deposition (CVD) method such as a plasma enhanced chemical vapor deposition (PECVD) method. And then an etch stop layer 111 is formed on a portion of the amorphous silicon layer 150. The second intrinsic semiconductor layer 114 is formed on one surface, for example, a back surface of a semiconductor 110, and the amorphous silicon layer 150 is formed of intrinsic hydrogenated amorphous silicon (a-Si:H).

The amorphous silicon layer 150 may be formed at a low temperature equal to or lower than 250 °C to have a thickness of 20 nm to 300 nm.

Next, as shown in FIG. 4B, a first dopant layer 162 containing impurities of a second conductive type opposite a first conductive type of the substrate 110 is formed on the amorphous silicon layer 150. Because the substrate 110 is of an n-type, the first dopant layer 162 contains impurities of a group III element of a p-type. The first dopant layer 162 may be formed using the CVD method such as the PECVD method.

Next, a diffusion barrier layer 180 may be formed on the first dopant layer 162. The diffusion barrier layer 180 prevents a diffusion of the first dopant layer 162 and is formed of an insulating material such as a polymer material.

Next, as shown in FIG. 4C, a dehydrogenation process is performed on the amorphous silicon layer 150 to remove hydrogen contained in the amorphous silicon layer 150. It is preferable, but not required, that the dehydrogenation process is performed at 300 to 600 °C.

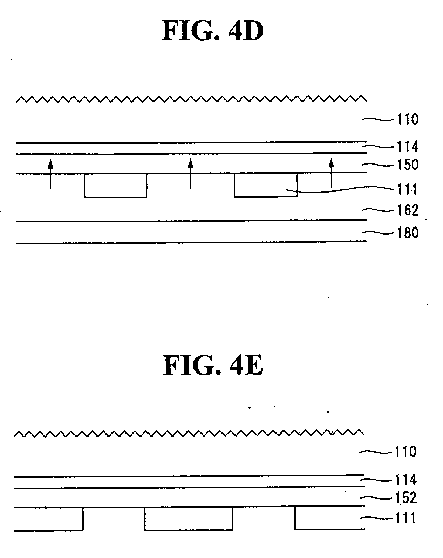

Next, as shown in FIG. 4D, a crystal layer (or a silicon layer) 152, in which at least a portion of the amorphous silicon layer 150 is crystallized, may be formed by diffusing impurities of the first dopant layer 162 and crystallizing (or partially crystallizing) the amorphous silicon layer 150 at the high temperature. After the crystal layer 152 is formed, the etch stop layer 111 and the diffusion barrier layer 180 are removed.

More specifically, a first diffusion process for diffusing second conductive type impurities of the first dopant layer 162 into a portion of the amorphous silicon layer 150 may be performed. The first diffusion process may be performed at a high temperature equal to or higher than 500 °C.

As described above, the portion of the amorphous silicon layer 150, into which the second conductive type impurities are diffused through the first diffusion process, is formed as a plurality of emitter regions 120. Namely, the plurality of emitter regions 120 may contain impurities of the second conductive type (for example, the p-type) opposite the first conductive type of the substrate 110.

At the same time, at least a portion of the amorphous silicon layer 150 forming the plurality of emitter regions 120 may be crystallized. The plurality of emitter regions 120 and the crystal layer 152 formed of amorphous silicon and crystalline silicon have the crystallinity of 20 % to 80 %.

Next, as shown in FIG. 4E, an etch stop layer 111 is formed on the crystal layer 152, of which a portion is crystallized.

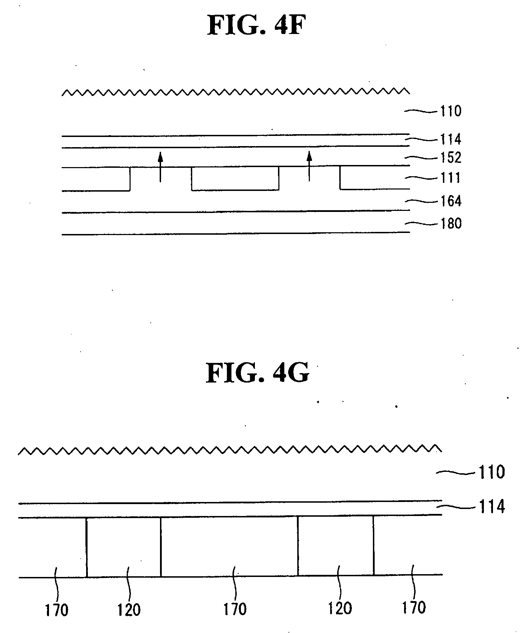

Next, as shown in FIG. 4F, a second dopant layer 164 containing impurities of the first conductive type is formed on the exposed portion of the crystal layer 152 and the etch stop layer 111. Because the substrate 110 is of the n-type, the second dopant layer 164 contains impurities of a group V element of the n-type. The second dopant layer 164 may be formed using the same method as the first dopant layer 162.

Next, a diffusion barrier layer 180 is formed on the second dopant layer 164. The diffusion barrier layer 180 prevents a diffusion of the second dopant layer 164 and is formed of an insulating material such as a polymer material.

Next, as shown in FIG. 4G, impurities of the second dopant layer 164 are diffused into the crystal layer 152 to form the plurality of emitter regions 120 and the plurality of back surface field regions 170.

More specifically, a second diffusion process for diffusing first conductive type impurities of the second dopant layer 164 into a remaining portion except the portion of the amorphous silicon layer 150 may be performed. Namely, the second diffusion process may be performed after the first diffusion process. The second diffusion process may be performed at a high temperature equal to or higher than 500 °C.

As described above, the remaining portion except the portion of the amorphous silicon layer 150, into which the first conductive type impurities are diffused through the second diffusion process, is formed as the plurality of back surface field regions 170. Namely, each of the plurality of back surface field regions 170 may be formed as a region (for example, n⁺ or n⁺⁺-type region) that is more heavily doped than the substrate 110 with impurities of the same conductive type as the n-type substrate 110. The plurality of emitter regions 120 and the plurality of back surface field regions 170 may be alternately formed.

The plurality of emitter regions 120 and the plurality of back surface field regions 170 formed of silicon may have the crystallinity of 20 % to 80 %.

A diffusion barrier layer 180 may be additionally formed between the emitter regions 120 and the back surface field regions 170, which are alternately positioned, and may prevent the emitter regions 120 and the back surface field regions 170 from being diffused.

Next, the plurality of first electrodes 141 are formed on the plurality of emitter regions 120, and the plurality of second electrodes 142 are formed on the plurality of back surface field regions 170. Hence, the solar cell 1 shown in FIG. 1 is completed.

## Claims

1. A method for manufacturing a solar cell (1), the method comprising:
forming a back tunnel junction layer (114) capable of generating a movement path of carriers on a back surface of a crystalline semiconductor substrate (110) containing impurities of a first conductive type;
forming an intrinsic hydrogenated amorphous silicon layer (150) on the back tunnel junction layer (114);
performing a dehydrogenation process on the intrinsic hydrogenated amorphous silicon layer (150) to remove hydrogen contained in the intrinsic hydrogenated amorphous silicon layer (150);
performing a first diffusion process for diffusing impurities of a second conductive type opposite the first conductive type into a portion of the intrinsic hydrogenated amorphous silicon layer (150) to form an emitter region (120);
performing a second diffusion process for diffusing impurities of the first conductive type with an impurity concentration higher than that of the substrate (110) into a remaining portion except the portion of the intrinsic hydrogenated amorphous silicon layer (150) having the impurities of the second conductive type to form a back surface field region (170); and
forming a first electrode (141) electrically connected to the emitter region (120) and a second electrode (142) electrically connected to the back surface field region (170),
wherein when the first diffusion process and the second diffusion process is performed, the intrinsic hydrogenated amorphous silicon layer (150) is crystallized to form a silicon layer (152) having a crystallinity of 20% to 80%, and
wherein the first diffusion process and the second diffusion process are simultaneously performed.

2. The method of claim 1, wherein when the first diffusion process and the second diffusion process are performed, the intrinsic hydrogenated amorphous silicon layer (150) is crystallized at a temperature equal to or higher than 500 °C.

3. The method of claim 2, wherein the intrinsic hydrogenated amorphous silicon layer (150) is formed at a temperature equal to or lower than 250°C.

4. The method of claim 1, wherein the intrinsic hydrogenated amorphous silicon layer (150) has a thickness of 20 nm to 300 nm.

5. The method of claim 1, wherein the intrinsic hydrogenated amorphous silicon layer (150) is formed at a temperature lower than the temperature of the first diffusion process and the second diffusion process.

6. The method of claim 1, further comprising forming a diffusion barrier layer (180) between the emitter region (120) and the back surface field region (170).

7. The method of claim 1, further comprising forming a front tunnel junction layer (112) capable of generating a movement path of carrier on a front surface of the crystalline semiconductor substrate.

8. The method of claim 7, wherein the front and back tunnel junction layers (112, 114) are formed of intrinsic hydrogenated amorphous silicon.

9. The method of claim 8, wherein the front and back tunnel junction layers (112, 114) have the same thickness or different thicknesses.

10. The method of claim 9, wherein the front and back tunnel junction layers (112, 114) have a thickness of 1 nm to 4 nm.

## Patentansprüche

1. Verfahren zum Herstellen einer Solarzelle (1), wobei das Verfahren umfasst:
Bilden einer rückseitigen Tunnelübergangsschicht (114), die fähig ist, einen Bewegungspfad für Träger auf einer rückseitigen Oberfläche eines kristallinen Halbleiter-Substrats (110), das Verunreinigungen eines ersten leitfähigen Typs enthält, zu erzeugen;
Bilden einer intrinsisch hydrierten amorphen Silizium-Schicht (150) auf der rückseitigen Tunnelübergangsschicht (114);
Durchführen eines Dehydrierungs-Vorgangs auf der intrinsisch hydrierten amorphen Silizium-Schicht (150), um Wasserstoff, der in der intrinsisch hydrierten amorphen Silizium-Schicht (150) enthalten ist, zu entfernen;
Durchführen eines ersten Diffusions-Vorgangs zum Diffundieren von Verunreinigungen eines zweiten leitfähigen Typs, der zu dem ersten leitfähigen Typ entgegengesetzt ist, in einen Abschnitt der intrinsisch hydrierten amorphen Silizium-Schicht (150), um eine Emitter-Region (120) zu bilden;
Durchführen eines zweiten Diffusions-Vorgangs zum Diffundieren von Verunreinigungen des ersten leitfähigen Typs mit einer Verunreinigungs-Konzentration, die höher ist als die des Substrats (110) in einen verbleibenden Abschnitt, ausgenommen des Abschnitts der intrinsisch hydrierten amorphen Silizium-Schicht (150) mit den Verunreinigungen des zweiten leitfähigen Typs, um eine rückseitige Oberflächen-Feldregion (170) zu bilden; und
Bilden einer ersten Elektrode (141), die elektrisch mit der Emitter-Region (120) verbunden ist, und einer zweiten Elektrode (142), die elektrisch mit der rückseitigen Oberflächen-Feldregion (170) verbunden ist,
wobei, wenn der erste Diffusionsvorgang und der zweite Diffusionsvorgang durchgeführt werden, die intrinsisch hydrierte amorphe Silizium-Schicht (150) kristallisiert wird, um eine Silizium-Schicht (152) mit einer Kristallinität von 20% bis 80% zu bilden, und
wobei der erste Diffusionsvorgang und der zweite Diffusionsvorgang gleichzeitig durchgeführt werden.

2. Verfahren nach Anspruch 1, wobei, wenn der erste Diffusionsvorgang und der zweite Diffusionsvorgang durchgeführt werden, die intrinsisch hydrierte amorphe Silizium-Schicht (150) bei einer Temperatur gleich zu oder höher als 500°C kristallisiert wird.

3. Verfahren nach Anspruch 2, wobei die intrinsisch hydrierte amorphe Silizium-Schicht (150) bei einer Temperatur gleich zu oder kleiner als 250°C gebildet wird.

4. Verfahren nach Anspruch 1, wobei die intrinsisch hydrierte amorphe Silizium-Schicht (150) eine Dicke von 20 nm bis 300 nm aufweist.

5. Verfahren nach Anspruch 1, wobei die intrinsisch hydrierte amorphe Silizium-Schicht (150) bei einer Temperatur unterhalb der Temperatur des ersten Diffusionsvorgangs und des zweiten Diffusionsvorgangs gebildet wird.

6. Verfahren nach Anspruch 1, des Weiteren umfassend das Bilden einer Diffusions-Sperrschicht (180) zwischen der Emitterregion (120) und der rückseitigen Oberflächen-Feldregion (170).

7. Verfahren nach Anspruch 1, des Weiteren umfassend das Bilden einer vorderen Tunnelübergangsschicht (112), die fähig ist einen Bewegungspfad für Träger auf einer vorderen Oberfläche des kristallinen Halbleitersubstrats zu erzeugen.

8. Verfahren nach Anspruch 7, wobei die vorderen und rückseitigen Tunnelübergangsschichten (112, 114) aus intrinsisch hydriertem amorphem Silizium gebildet werden.

9. Verfahren nach Anspruch 8, wobei die vorderen und rückseitigen Tunnelübergangsschichten (112, 114) die gleiche Dicke oder verschiedene Dicken aufweisen.

10. Verfahren nach Anspruch 9, wobei die vorderen und rückseitigen Tunnelübergangsschichten (112, 114) eine Dicke von 1 nm bis 4 nm aufweisen.

## Revendications

1. Procédé de fabrication d'une cellule solaire (1), le procédé comprenant :
la formation d'une couche de jonction (114) à effet tunnel arrière apte à générer une trajectoire de déplacement de porteurs sur une surface arrière d'un substrat semi-conducteur cristallin (110) contenant des impuretés d'un premier type de conductivité ;
la formation d'une couche de silicium (150) amorphe hydrogéné intrinsèque sur la couche de jonction (114) à effet tunnel arrière ;
la réalisation d'un processus de déshydrogénation sur la couche de silicium (150) amorphe hydrogéné intrinsèque pour éliminer l'hydrogène contenu dans la couche de silicium (150) amorphe hydrogéné intrinsèque ;
la réalisation d'un premier processus de diffusion pour diffuser des impuretés d'un deuxième type de conductivité opposé au premier type de conductivité dans une partie de la couche de silicium amorphe (150) hydrogéné intrinsèque afin de former une région d'émetteur (120) ;
la réalisation d'un deuxième processus de diffusion pour diffuser des impuretés du premier type de conductivité avec une concentration en impuretés supérieure à celle du substrat (110) dans une partie restante à l'exception de la partie de la couche de silicium (150) amorphe hydrogéné intrinsèque ayant les impuretés du deuxième type de conductivité pour former une région de champ (170) de surface arrière ; et
la formation d'une première électrode (141) connectée électriquement à la région d'émetteur (120) et d'une deuxième électrode (142) connectée électriquement à la région de champ (170) de surface arrière,
dans lequel, lorsque le premier processus de diffusion et le deuxième processus de diffusion sont réalisés, la couche de silicium (150) amorphe hydrogéné intrinsèque est cristallisée pour former une couche de silicium (152) ayant une cristallinité de 20 % à 80 %, et
dans lequel le premier processus de diffusion et le deuxième processus de diffusion sont réalisés simultanément.

2. Procédé selon la revendication 1, dans lequel, lorsque le premier processus de diffusion et le deuxième processus de diffusion sont réalisés, la couche de silicium (150) amorphe hydrogéné intrinsèque est cristallisée à une température supérieure ou égale à 500 °C.

3. Procédé selon la revendication 2, dans lequel la couche de silicium (150) amorphe hydrogéné intrinsèque est formée à une température inférieure ou égale à 250 °C.

4. Procédé selon la revendication 1, dans lequel la couche de silicium (150) amorphe hydrogéné intrinsèque a une épaisseur de 20 nm à 300 nm.

5. Procédé selon la revendication 1, dans lequel la couche de silicium (150) amorphe hydrogéné intrinsèque est formée à une température inférieure à la température du premier processus de diffusion et du deuxième processus de diffusion.

6. Procédé selon la revendication 1, comprenant en outre la formation d'une couche formant barrière à la diffusion (180) entre la région d'émetteur (120) et la région de champ (170) de surface arrière.

7. Procédé selon la revendication 1, comprenant en outre la formation d'une couche de jonction (112) à effet tunnel avant apte à générer une trajectoire de déplacement de porteur sur une surface avant du substrat semi-conducteur cristallin.

8. Procédé selon la revendication 7, dans lequel les couches de jonction (112, 114) à effet tunnel avant et arrière sont formées de silicium amorphe hydrogéné intrinsèque.

9. Procédé selon la revendication 8, dans lequel les couches de jonction (112, 114) à effet tunnel avant et arrière ont la même épaisseur ou des épaisseurs différentes.

10. Procédé selon la revendication 9, dans lequel les couches de jonction (112, 114) à effet tunnel avant et arrière ont une épaisseur de 1 nm à 4 nm.
